# EUROPÄISCHE PATENTANMELDUNG

(11) **EP 1 684 566 A2**
(43) Veröffentlichungstag der Anmeldung: **26.07.2006**
(21) Anmeldenummer: 05112549.0
(22) Anmeldetag: 21.12.2005
(51) Int. Cl.: H05K 13/04

(54) **Zuführeinrichtung für elektrische Bauelemente**

(30) Priorität: 19.01.2005 DE 102005002567
(71) Anmelder: SIEMENS AKTIENGESELLSCHAFT, 80333 München (DE)
(72) Erfinder: Völker, Frank, 78315, Radolfzell/Stahringen (DE)

(57) **Zusammenfassung**

Die Erfindung betrifft eine Zuführeinrichtung (1), insbesondere für elektrische Bauelemente (5), mit einem Transportrad (6), welches entlang seines Außenumfangs Stifte (7) aufweist, die in entsprechende Perforationen (12) eines Bauelementegurts (3) eingreifen, um den Bauelementegurt (3) in einer Transportrichtung zu transportieren, und welches in einem Spalt (13) verläuft, der durch zwei sich in Transportrichtung erstreckende Wandabschnitte (14) der Zuführeinrichtung (1) gebildet wird, wobei die Zuführeinrichtung (1) ein Abdeckelement (15) aufweist, welches den Spalt (13) abdeckt.

## Beschreibung

Die Erfindung bezieht sich auf eine Zuführeinrichtung, insbesondere zum Fördern von mit Bauelementen beladenen Bauelementegurten.

Eine derartige Zuführeinrichtung ist aus der Offenlegungsschrift DE 10020748 bekannt. Danach umfasst die Zuführeinrichtung ein Transportrad, welches an seinem Außenumfang Stifte aufweist, die in entsprechende Perforationen des Bauelementegurts, welcher die Bauelemente in taschenartigen Vertiefungen trägt, eingreift. Durch Drehen des Transportrades werden die Bauelemente auf diese Weise sukzessive zu einer Abholposition transportiert, an welcher die Bauelemente beispielsweise durch einen Bestückkopf aufgenommen werden. Das Transportrad läuft in der Regel in einem Spalt, der durch zwei sich in der Transportrichtung des Gurtes erstreckende Wandabschnitte der Zuführeinrichtung gebildet wird. Da das Transportrad meistens nahe der Abholposition der Zuführeinrichtung angeordnet ist, kommt es immer wieder vor, dass die in den taschenartigen Vertiefungen des Bauelementgurtes an dieser Stelle frei liegenden Bauelemente durch die ruckartigen Transportbewegungen oder durch Fehler beim Abholen durch den Bestückkopf in den Spalt, in welchem das Transportrad verläuft, gelangen. Die Bauelemente können sich dann beispielsweise in der Antriebsmechanik des Transportrades verklemmen und dort Schaden anrichten.

Es ist deshalb die Aufgabe der vorliegenden Erfindung, eine Zuführeinrichtung mit einer erhöhten Betriebssicherheit zu liefern.

Die Aufgabe wird durch eine Zuführeinrichtung gemäß dem unabhängigen Anspruch 1 gelöst. Danach weist die Zuführeinrichtung ein Abdeckelement auf, welches den Spalt, in dem das Transportrad verläuft, so abdeckt, dass ein Eindringen von Bauelementen wirksam verhindert wird. Insbesondere beim Transport von sehr kleinen Bauelementen kann somit die Gefahr, dass ein Bauelement durch den Spalt bis in die Antriebsmechanik der Zuführeinrichtung gelangt und dort Schaden bis hin zu einem Stillstand der Zuführeinrichtung anrichtet, wirkungsvoll unterbunden werden. Dadurch wird die Betriebssicherheit der Zuführeinrichtung erheblich gesteigert.

Nach einer Ausgestaltung gemäß Anspruch 2 umfasst die Zuführeinrichtung ein Endlosband, welches am Außenumfang des Transportrades mit den Stiften in Eingriff steht. Das Endlosband wird dabei so in der Zuführeinrichtung geführt, dass es zwischen dem Spalt, welcher das Transportrad aufnimmt, und dem Bauelementegurt, genauer gesagt, dem Teil des Bauelementegurtes, welcher die Perforationen aufweist, verläuft. Durch diese Anordnung wird der Spalt, in dem das Transportrad verläuft, sicher vor herabfallenden Bauelementen geschützt, ohne dass der Vorschub des Bauelementegurtes beeinträchtigt wird.

Die Zuführeinrichtung kann gemäß Anspruch 3 auch dahingehend ausgestaltet werden, dass die den Spalt begrenzenden Wandabschnitte jeweils auf ihren dem Spalt zugewandten Seitenflächen eine Führungsnut aufweisen, in der das Endlosband verläuft und geführt wird. Dies erlaubt eine noch sichere Abdeckung des Spaltes und damit eine weitere Verbesserung der Betriebssicherheit der Zuführeinrichtung.

Gemäß der Ausgestaltung nach Anspruch 4 steht das Endlosband entlang des gesamten Umfanges des Transportrades mit den Stiften in Eingriff. Ein derart gestaltetes Endlosband liegt demnach eng entlang der gesamten äußeren Peripherie des Transportrades an, wodurch die Länge des Endlosbandes maximal dem Umfang des Transportrades entspricht. Das Endlosband wird günstigerweise aus elastischem Material hergestellt, beispielsweise aus einem Elasthomer, was eine einfache Montage des Endlosbandes am Transportrad, sowie, durch die gummielastische Kontraktion des Endlosbandes, einen sicheren Halt auf dem Transportrad gewährleistet. Des Weiteren sind die Kosten für ein derartiges Endlosband sehr niedrig.

Für bestimmte Anwendungen kann das Endlosband gemäß einer Ausgestaltung nach Anspruch 5 nur teilweise mit den Stiften des Transportrades in Eingriff stehen. Dies sollte günstigerweise in einem Bereich geschehen, wo das Transportrad auch mit den Perforationen des Bauelementegurtes in Eingriff steht. Um das Endlosband dort, wo es mit den Stiften nicht in Eingriff steht, entlang einer beliebigen Verlaufsstrecke innerhalb des Gehäuses der Zuführeinrichtung führen zu können, können im Gehäuse der Zuführeinrichtung entsprechende Führungselemente vorgesehen werden.

Um dem Endlosband eine gewisse Spannung zu verleihen, kann in einem Bereich, in dem das Endlosband nicht mit den Stiften in Eingriff steht, eine Spannvorrichtung im Gehäuse der Zuführeinrichtung vorgesehen werden. Eine derartige Spannvorrichtung könnte z. B. durch eine gefedert gelagerte Führungsrolle realisiert werden. Durch die Vorspannung des Endlosbandes wird gewährleistet, dass das Endlosband immer sicher am Transportrad anliegt.

Die Zuführeinrichtung kann gemäß einer Ausgestaltung nach Anspruch 7 ein Mittel zum Säubern des Endlosbandes aufweisen, um Schmutz oder am Endlosband anhaftende Bauelemente von diesen zu entfernen. Ein derartiges Mittel zum Säubern des Endlosbandes könnte beispielsweise eine Bürste sein, deren Borsten über die Oberfläche des bewegten Endlosbandes streifen. Die Bürste wird dabei im Gehäuse der Zuführeinrichtung derart vorgesehen, dass in der Falllinie der Bauteile unterhalb der Bürste keine mechanisch beweglichen Elemente z. B. des Antriebsmechanismus des Transportrades liegen.

Das Mittel zum Säubern des Endlosbandes kann gemäß Anspruch 8 unterhalb des Eingriffspunktes eines Antriebsmotors in ein Getriebe des Transportrades angeordnet sein, so dass die durch die Bürste vom Endlosband abgestreiften Bauelemente oder Verschmutzungen nicht in die beweglichen Teile des Antriebsmotors oder des Getriebes fallen, wodurch die Betriebssicherheit der Zuführeinrichtung weiter gesteigert wird.

Um die von der Bürste abgestreiften Bauelemente oder Verschmutzungen kontrolliert aus dem Gehäuse der Zuführeinrichtung abzuführen, ist gemäß Anspruch 9 in einer Fallrichtung bzw. unterhalb der Bürste ein Entsorgungskanal angeordnet, der günstigerweise trichterförmig ausgebildet sein kann. Dadurch wird sichergestellt, dass die abgebürsteten Bauelemente bzw. Verschmutzungen nicht auf andere Komponenten der Zuführeinrichtung fallen und diese eventuell beschmutzen oder beschädigen.

Im Folgenden werden zwei Ausführungsbeispiele der erfindungsgemäßen Zuführeinrichtung anhand der beigefügten Figuren näher erläutert, wobei
Figur 1 ein erstes Ausführungsbeispiel der erfindungsgemäßen Zuführeinrichtung,
Figur 2 eine Querschnittsansicht des in Figur 1 bzw. in Figur 4a gezeigten Zuführeinrichtung jeweils entlang der Linie A,
Figur 3 eine Querschnittsansicht einer alternativen Ausgestaltung der Zuführeinrichtungen, wie sie in Figur 1 bzw. in Figur 4a gezeigt sind,
Figur 4a ein zweites Ausführungsbeispiel der erfindungsgemäßen Zuführeinrichtung, und
Figur 4b eine Querschnittsansicht der in Figur 4a gezeigten Zuführeinrichtung entlang der Linie A, darstellen.

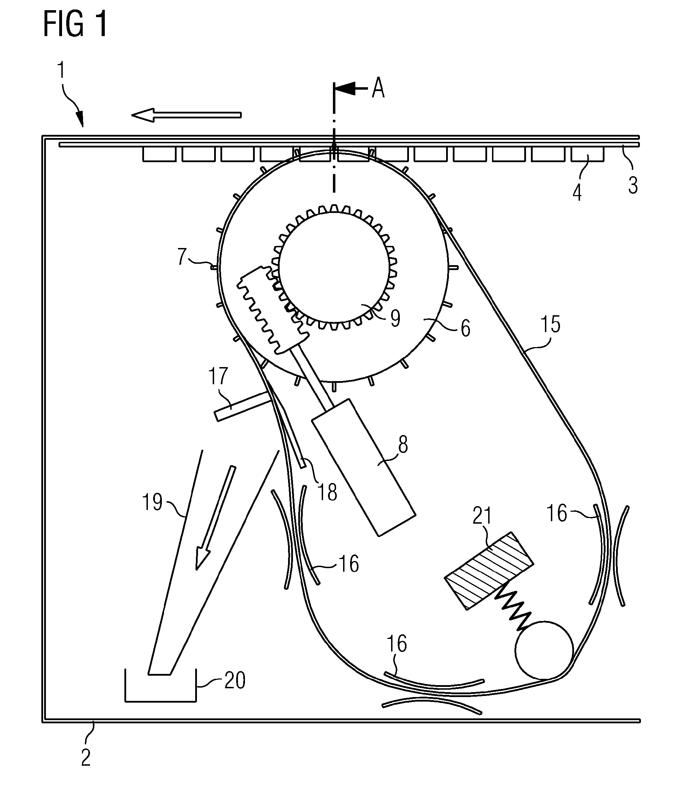

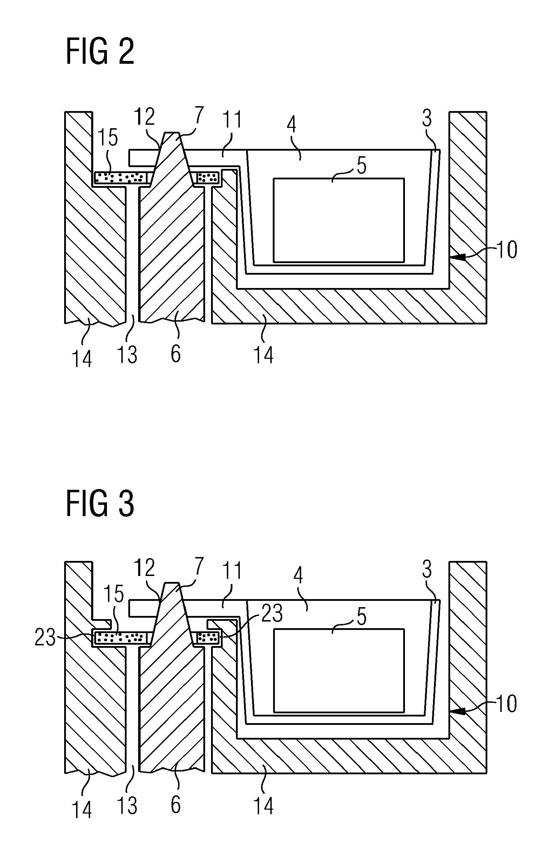

Figur 1 zeigt eine schematische Ansicht eines Ausführungsbeispiels der erfindungsgemäßen Zuführeinrichtung 1. Die Zuführeinrichtung 1 weist ein Gehäuse 2 auf, in der der Antriebsmechanismus für einen zu transportierenden Bauelementegurt 3 vorgesehen ist. Der Bauelementegurt 3 weist taschenartige Vertiefungen 4 auf (siehe Figur 2), in denen die Bauelemente 5 vorgesehen sind. Der Bauelementegurt 3 wird mittels eines Transportrades 6 in einer definierten Schrittweite und Taktzeit in einer (durch einen Pfeil dargestellten) Transportrichtung transportiert. An einer Abholposition werden die Bauelemente 5 von einem (nicht dargestellten) Bestückkopf eines Bestückautomaten aus den Taschen entnommen. Das scheibenförmige Transportrad 6 weist an seinem äußeren Umfang radial abstehende Stifte 7 auf, welche mit dem Bauelementegurt 3 derart in Eingriff stehen, dass ein sicherer Vorschub des Bauelementegurtes 3 gewährleistet ist. Ein Motor 8 zum Antrieb des Transportrades 6 steht über ein Schneckengetriebe 9 mit dem Transportrad 6 in Eingriff. Der Motor 8 wird über eine (nicht dargestellte) Steuereinrichtung derart gesteuert, dass die Bauelemente 5 exakt und zur richtigen Zeit an die Abholposition transportiert werden.

Figur 2 stellt eine schematische Querschnittsansicht der in Figur 1 gezeigten Zuführeinrichtung 1 in Richtung der Schnittlinie A dar, wobei nur der Ausschnitt gezeigt wird, wo das Transportrad 6 mit dem Bauelementegurt 3 in Eingriff steht. Wie zu erkennen ist, verläuft der Teil des Bauelementegurtes 3, an dem die taschenartigen Vertiefungen 4 vorgesehen sind, in einem U-förmig ausgebildeten Führungskanal 10. Ein an der oberen Kante des Bauelementegurtes 3 seitlich abstehender Fortsatz 11 des Bauelementegurtes 3 weist Perforationen 12 auf, in die die Stifte 7 des Transportrades 6 eingreifen können, um so den Bauelementegurt 3 anzutreiben. Das Transportrad 6 verläuft dabei in einem Spalt 13, welcher seitlich durch Wandabschnitte 14 der Zuführeinrichtung 1 begrenzt wird. Der Spalt 13 wird durch einen kreisrunden Aufnahmeraum für das Transportrad 6 gebildet, welcher in den Gehäusekörper der Zuführeinrichtung 1 eingefräst und mittels einer Seitenwand der Zuführeinrichtung 1 abgedeckt ist. Zumindest an den Stellen, an denen die Stifte 7 mit den Perforationen 12 des Bauelementegurtes 3 in Eingriff stehen, ragt ein Teil der Stifte 7 bzw. ein Teil des Transportrades 6 aus dem Spalt 13 heraus.

Beim Vorschub des Bauelementegurtes 3 treten oft sehr hohe Beschleunigungen auf. Durch den teilweise ruckartigen Vorschub des Bauelementegurtes 3 kommt es immer wieder vor, dass Bauelemente 5 im Bereich des Spaltes 13, in dem das Transportrad 6 verläuft, aus den taschenartigen Vertiefungen 4 des Bauelementegurts 3 herausspringen. Insbesondere bei kleinen Bauelementen mit Abmessungen im Millimeterbereich kann es vorkommen, dass sich ein Bauelement 5 in den Spalt 13 des Transportrades 6 verirrt, nach unten durchfällt und beispielsweise im Antriebsmechanismus des Transportrades 6 Schaden anrichtet. Dies kann schlimmstenfalls bis zum Stillstand der Zuführeinrichtungen 1 führen. Bei einem Ausfall der Zuführeinrichtung 1 kommt es zu erheblichen Verzögerungen des Bestückprozesses.

Um die Betriebssicherheit einer derartigen Zuführeinrichtung 1 zu verbessern, liegt der Erfindung die Idee zugrunde, ein Abdeckelement 15 vorzusehen, welches den Spalt 13, in dem das Transportrad 6 verläuft, sicher abdeckt.

In dem in Figur 1 dargestellten Ausführungsbeispiel der erfindungsgemäßen Zuführeinrichtung 1 ist das Abdeckelement 15 als Endlosband 15 ausgebildet, welche mit den Stiften 7 des Transportrades 6 in Eingriff steht. Wie in Figur 2 dargestellt, verläuft das Endlosband 15 in den Bereichen, in denen die Stifte 7 des Transportrades 6 mit den Perforationen 12 des Bauelementegurtes 3 in Eingriff steht, zwischen dem seitlichen Fortsatz 11 des Bauelementegurtes 3 und dem Spalt 13, in dem das Transportrad 6 verläuft. Das Endlosband 15 wird dadurch durch die Drehung des Transportrades 6 in einer Endlosschleife mit transportiert, wobei es aufgrund seiner Anordnung zwischen dem Bauelementegurt 3 und dem Spalt 13 den eigentlichen Vorschub des Bauelementegurtes 3 nicht behindert.

Wie aus Figur 2 weiter hervorgeht, ist das Endlosband 15 deutlich breiter ausgestaltet als der Spalt 13. Dies ist dadurch möglich, dass die den Spalt 13 bildenden Wandabschnitte 14 der Zuführeinrichtung 1 auf ihren dem Transportrad 6 zugewandten Seiten jeweils einen umlaufenden Absatz aufweisen, auf dem das Endlosband 15 geführt wird. Somit wird erreicht, dass das Endlosband 15 den Spalt 13 bzw. den Aufnahmeraum des Transportrads 6 sicher abdeckt.

Figur 3 zeigt eine alternative Querschnittsansicht in Richtung der Querschnittslinie A aus Figur 1. Die in Figur 3 gezeigte Querschnittsansicht unterscheidet sich von der Querschnittsansicht gemäß Figur 2 dadurch, dass die den Spalt 13 bildenden Wandabschnitte 14 der Zuführeinrichtung 1 auf ihren dem Spalt 13 zugewandten Seiten jeweils eine Führungsnut 23 aufweisen, in der das Endlosband 15 verläuft. Die Führungsnut 23 kann umlaufend ausgebildet sein, was dem Endlosband 15 einen sehr sicheren Verlauf innerhalb der Zuführeinrichtung 1 ermöglicht.

Bei der in Figur 1 dargestellten Ausgestaltung der erfindungsgemäßen Zuführeinrichtung 1 steht das Endlosband 15 nur teilweise mit den Stiften 7 des Transportrads 6 in Eingriff. Dies ist vor allem im Bereich der oberen Hälfte des Transportrads 6 der Fall, wo die Stifte 7 mit den Perforationen 12 des Bauelementegurtes 3 in Eingriff stehen und ein Eindringen von verloren gegangenen Bauelementen am wahrscheinlichsten ist. Im Bereich der unteren Hälfte des Transportrades 6 verlässt der Verlauf des Endlosbandes 15 das Transportrad 6 und kann, durch Führungselemente 16 geleitet, beliebig im Gehäuse 2 der Zuführeinrichtung 1 geführt werden. Der Zweck der Führungselemente 16 ist es, den Verlauf des Endlosbandes 15 im Gehäuse 2 der Zuführeinrichtung 1 entsprechend den räumlichen Gegebenheiten innerhalb des Gehäuses 2 anzupassen. Bei einem derart geführten Endlosband 15 bietet sich der Vorteil, in einem Bereich, in dem das Endlosband 15 nicht mit den Stiften 7 in Eingriff steht, ein Mittel 17 zum Säubern des Endlosbandes 15 vorzusehen. Ein derartiges Mittel 17 kann beispielsweise durch eine Bürste 17 realisiert werden, deren Borsten über die Oberfläche des Endlosbandes 15 streifen, um auf dem Endlosband 15 anhaftende Bauelemente 5 oder Verunreinigungen abzustreifen. Um zu gewährleisten, dass die Bürste 17 sicher am Endlosband 15 anliegt, kann auf der gegenüberliegenden Seite ein Konterelement 18 vorgesehen werden, so dass das Endlosband 15 zwischen der Bürste 17 und dem Konterelement 18 verläuft, und die Borsten der Bürste 17 das Endlosband 15 gegen das Konterelement 18 drücken. Die Bürste 17 wird idealerweise an einem Bereich innerhalb der Zuführeinrichtung 1 vorgesehen, in dem sich keine beweglichen Funktionsteile in der Falllinie der Bauelemente 5 befinden. Ist dies aus Platzgründen nicht möglich, so kann es sinnvoll sein, unterhalb der Bürste 17 einen trichterförmigen Entsorgungskanal 19 für die Bauelemente 5 vorzusehen, welcher diese kontrolliert beispielsweise in einen Sammelbehälter 20 abführt.

Die Länge des Spalts 13, in dem das Transportrad 6 verläuft, sollte in Transportrichtung vorteilhafterweise so lange sein, dass die Stifte 7 des Transportrades 6 mit dem Bauelementegurt 3 in Eingriff gebracht werden können. Je geringer die Länge des Spalts 13, desto geringer ist die Wahrscheinlichkeit, dass Bauelemente 5 in den Spalt 13 eindringen.

Weiterhin kann es, wie in Figur 1 gezeigt, vorteilhaft sein, innerhalb des Gehäuses 2 der Zuführeinrichtung 1 eine Spanneinrichtung 21 zum Vorspannen des Endlosbandes 15 vorzusehen. Die Spannvorrichtung sollte sich in einem Bereich befinden, in dem das Endlosband 15 nicht mit den Stiften 7 des Transportrades 6 in Eingriff steht. Durch die Vorspannung des Endlosbandes 15 wird gewährleistet, dass das Endlosband 15 immer sicher am Transportrad 6 anliegt. Ein Abspringen des Endlosbandes 15 vom Transportrad 6 wird dadurch vermieden.

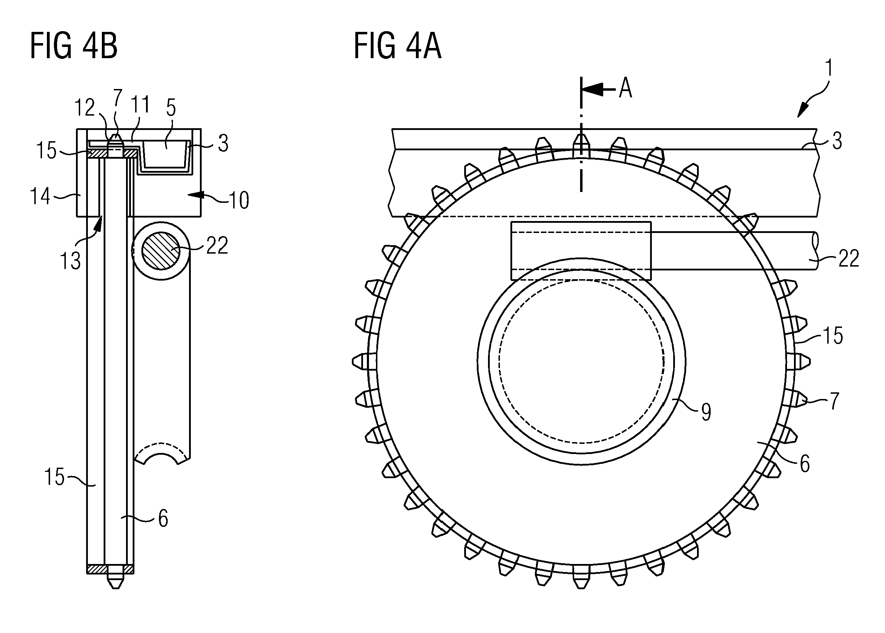

In den Figuren 4a und 4b ist ein zweites Ausführungsbeispiel der erfindungsgemäßen Zuführeinrichtung 1 ausschnitthaft dargestellt. Bei diesem Ausführungsbeispiel steht das Endlosband 15 entlang des gesamten Umfangs des Transportrades 6 mit den Stiften 7 in Eingriff. Das günstigerweise aus einem elasthomerischen Material hergestellte Endlosband 15 liegt demnach vollständig an der äußeren Peripherie des Transportrades 6 an. Wie in Figur 4b dargestellt, sollte das Endlosband 15 jedoch eine Breite aufweisen, die so angepasst ist, dass die Antriebswelle 22 des Motors 8 zum Antrieb des Transportrades 6 noch so an dem Endlosband 15 vorbeigeführt werden kann, so dass ein Kontakt der Antriebswelle 22 mit dem Endlosband 15 bzw. ein Reiben des Endlosbandes 15 an der Antriebswelle 22 sicher vermieden wird. Diese Ausgestaltung des Endlosbandes 15 bietet den Vorteil, dass es nicht innerhalb des Gehäuses 2 der Zuführeinrichtung 1 mittels Führungselementen 16 geführt werden muss was manchmal aus Platzmangel gar nicht möglich ist. Nichtsdestotrotz kann auch in diesem Fall ein Mittel 17 zum Säubern des Endlosbandes 15 vorgesehen werden, welches günstigerweise unterhalb des Eingriffspunktes des Antriebsmotors in das Getriebe 9 des Transportrades 6 vorgesehen ist. Ferner kann unterhalb der Eingriffstelle des Mittels zum Säubern des Endlosbandes 15 ein trichterförmiger Entsorgungskanal 19 für abgestreifte Bauelemente 5 vorgesehen werden, wie es im Rahmen des ersten Ausführungsbeipiels in Figur 1 schon erläutert wurde.

Es ist zu beachten, dass die in den Figuren 2 und 3 dargestellten Ausgestaltungen auch auf das anhand der Figuren 4a und 4b beschriebene Ausführungsbeispiel übertragbar sind.

Bezugszeichenliste
- 1: Zuführeinrichtung
- 2: Gehäuse
- 3: Bauelementegurt
- 4: Vertiefungen
- 5: Bauelemente
- 6: Transportrad
- 7: Stifte
- 8: Motor
- 9: Schneckengetriebe
- 10: Führungskanal
- 11: Fortsatz
- 12: Perforationen
- 13: Spalt
- 14: Wandabschnitte
- 15: Abdeckelement / Endlosband
- 16: Führungselemente
- 17: Mittel zum Säubern / Bürste
- 18: Konterelement
- 19: Entsorgungskanal
- 20: Sammelbehälter
- 21: Spanneinrichtung
- 22: Antriebswelle
- 23: Führungsnut

## Patentansprüche

1. Zuführeinrichtung (1), insbesondere für elektrische Bauelemente (5), mit einem Transportrad (6), welches entlang seines Außenumfangs Stifte (7) aufweist, die in entsprechende Perforationen (12) eines Bauelementegurts (3) eingreifen, um den Bauelementegurt (3) in einer Transportrichtung zu transportieren, und welches in einem Spalt (13) verläuft, der durch zwei sich in Transportrichtung erstreckende Wandabschnitte (14) der Zuführeinrichtung (1) begrenzt wird, wobei die Zuführeinrichtung (1) ein Abdeckelement (15) aufweist, welches den Spalt (13) abdeckt.

2. Zuführeinrichtung (1) nach Anspruch 1, **dadurch gekennzeichnet, dass** das Abdeckelement (15) als ein am Außenumfang des Transportrads (6) mit den Stiften (7) in Eingriff stehendes Endlosband (15) ausgebildet ist, welches zwischen dem Bauelementegurt und dem Spalt (13) verläuft.

3. Zuführeinrichtung (1) nach Anspruch 2, **dadurch gekennzeichnet, dass** die Wandabschnitte (14) auf Seiten des Spalts (13) jeweils eine Führungsnut (23) aufweisen, in der das Endlosband (15) verläuft.

4. Zuführeinrichtung (1) nach einem der Ansprüche 2 bis 3, **dadurch gekennzeichnet, dass** das Endlosband (15) entlang des gesamten Umfangs des Transportrads (6) mit den Stiften (7) des Transportrads (6) in Eingriff steht.

5. Zuführeinrichtung (1) nach einem der Ansprüche 2 bis 3, **dadurch gekennzeichnet, dass** das Endlosband (15) nur teilweise mit den Stiften (7) des Transportrads (6) in Eingriff steht und in einem Bereich, in dem die das Endlosband (15) nicht mit den Stiften (7) in Eingriff steht, durch Führungselemente (16) geführt wird.

6. Zuführeinrichtung (1) nach Anspruch 5, **gekennzeichnet durch** eine elastische Spanneinrichtung (21) zum Vorspannen des Endlosbands (15) in einem Bereich, in dem die das Endlosband (15) nicht mit den Stiften (7) in Eingriff steht

7. Zuführeinrichtung (1) nach einem der Ansprüche 2 bis 6, **dadurch gekennzeichnet, dass** das die Zuführeinrichtung (1) ein Mittel (17) zum Säubern des Endlosbands (15) aufweist, um am Endlosband (15) anhaftende Bauelemente (5) zu entfernen.

8. Zuführeinrichtung (1) nach Anspruch 7, **dadurch gekennzeichnet, dass** das Mittel (17) zum Säubern des Endlosbands (15) unterhalb des Eingriffpunkts eines Antriebmotors in ein Getriebe (9) des Transportrads (6) angeordnet ist.

9. Zuführeinrichtung (1) nach eine der Ansprüche 7 bis 8, **dadurch gekennzeichnet, dass** in einer Fallrichtung unterhalb des Mittels zum Säubern des Endlosbands (15) ein Entsorgungskanal (19) angeordnet ist, um entfernte Bauelemente (5) kontrolliert aufzufangen.
